# EUROPEAN PATENT SPECIFICATION

(11) **EP 2 790 214 B1**
(45) Date of publication and mention of the grant of the patent: **01.01.2020**
(21) Application number: 13001860.9
(22) Date of filing: 10.04.2013
(51) Int. Cl.: H01L 23/13, H01L 23/498

(54) **Device with a micro- or nanoscale structure**
Vorrichtung mit einer mikro- oder nanoskaligen Struktur
Dispositif avec structure micro ou nanométrique

(43) Date of publication of application: 15.10.2014
(73) Proprietor: Invensense, Inc., San Jose, California 95110 (US)
(72) Inventor: Mayer, Felix, 8712 Stäfa (CH)
(74) Representative: Smith, Jeremy Robert

(56) References cited:
- EP-A1- 2 421 037
- DE-A1-102009 046 692
- US-A1- 2008 016 683
- US-A1- 2008 036 082

## Description

### Technical Field

The present invention relates to a device with a micro- or nanoscale structure, and in particular with one or more of a micro- or nanoscale mechanical structure, a micro- or nanoscale sensing element, an active and/or passive micro- or nanoscale electrical circuitry.

### Background Art

In many devices comprising electronic and/or mechanical integrated structures including sensing elements these structures may be sensitive to stress. When such structures are applied to a front side of a substrate, the device may be arranged with its back side on a carrier and be electrically connected thereto by means of electrically conducting vias through the substrate.

It was observed that during mounting of such device to the carrier, and/or later on during operation, mechanical stress may be evoked and transmitted via solder balls to the substrate and specifically to stress sensitive structures of the device and may damage such structures.

### Disclosure of the Invention

The problem to be solved by the present invention is therefore to provide a device that is more resistant to mechanical stress induced by the mechanical link between a carrier and the device.

This problem is solved by a device with one or more of a micro- or nanoscale mechanical structure, a micro- or nanoscale sensing element, an active and/or passive micro- or nanoscale electrical circuitry according to the features of claim 1. The device comprises a substrate with a front side and a back side. Front and back side typically refer to opposite planes of the substrate, wherein in most instances the dimensions defining the front and back side i.e. the length and the width of the substrate exceed the height of the substrate. The substrate may preferably be a semiconductor substrate, and specifically a silicon substrate, however, in other embodiments the substrate may be a glass or a ceramic substrate. Circuitry is arranged at the front side of the substrate.

The device contains a micro- or nanoscale structure. Microscale structures in this context shall encompass structures between 1 micrometer and 1000 micrometers, and in an embodiment between 1 micrometer and 100 micrometers, while nanoscale structures shall encompass structures between 1 nanometer and 1000 nanometers. In case the micro-or nanoscale structure comprises an electrical circuitry, such circuitry may comprise passive structures such as resistors which shall include resistors of electrical interconnections in the form of conducting paths, and/or may include other passive structures such as capacitors, inductances, etc.. And/or the circuitry may include active structures, i.e. electronics, comprising, e.g. transistors, diodes, etc.. In view of the scale of the circuitry, it is preferred that macroscale circuitry structures such a circuitry on a printed circuit board are excluded. The device may in addition or alternatively comprise a micro- or nanoscale mechanical structure such as a micromachine, a mechanical resonator, etc. which structure preferably is electrically connected by means of interconnections. The device may in addition or alternatively comprise a micro- or nanoscale sensing element.

Preferably, the one or more structures are integrated at the front side of the substrate which shall include an arrangement onto the front side of the substrate or an integration into the substrate at the front side by means of processes for manufacturing such micro-or nanoscale structures, such as CMOS processes, MEMS processes, NEMS processes, etc.

The structure at the front side of the substrate may in a preferred embodiment include one or more of the following: circuitry in form of bare electrically conducting paths, such as aluminium or copper paths; an electronic circuitry, and preferably an integrated active electronic circuitry, which specifically may also be an ASIC (application specific integrated circuit); a sensing element; a micro- or nanoscale structure; a micromechanical structure; a MEMS (microelectromechanical) structure; a NEMS (nanoelectromechanical) structure. In case the device includes a sensing element, the sensing element preferably is an element for sensing at least one of pressure, humidity, a chemical substance, a flow of a fluid including the flow of a liquid or the flow of a gas, temperature, stress, electromagnetic radiation such as light, or mechanical vibration including mechanical resonance.

In a preferred embodiment, the device is one of an integrated circuit, a MEMS device, a NEMS device, a sensor, or a combination thereof.

Any of such circuitry, mechanical structure or sensing element, alone or in combination, which is arranged at the front side of the substrate, is preferably electrically connected to the outside world, i.e. to circuits outside the device. Contact pads for doing so are arranged at the back side of the substrate, however not at the substrate itself but on a support for the substrate. One or more vias extend through the substrate between the front side and the back side for electrically connecting the one or more of the circuitry, mechanical structure or sensing element - collectively denoted as structure - on the front side to the contact pads on the support. Hence, the one or more vias extend vertically through the substrate between its front and back side. The vias represent an electrically conducting path through the substrate. Preferably, through holes in the substrate that may be manufactured by etching or laser drilling, for example, are filled with a conductive material such as aluminium. In one embodiment, a through hole for a via may completely be filled by the conductive material while in another embodiment only the walls of the through hole may be covered by the conductive material. At the back side of the substrate the support is arranged and preferably attached to the substrate e.g. by gluing. The support has electrical interconnections for electrically connecting the vias to the contact pads, and specifically for connecting each via to a single one assigned contact pad. Hence, the support may also be referred to as redistribution layer given that vias may be formed at defined locations of the substrate and that the contact pads may be arranged at different locations subject to the application or subject to the client. Hence, the redistribution layer assumes the task of providing variability in the interface pattern to the outside world. The electrically conductive pattern at the back side of the support may, except for the contact pads, be covered by a lacquer or other protection means. Conductive means may be applied to the contact pads such as a conductive paste or solder balls.

The support comprises at least a first member and a second member, which preferably are made from a single piece of material. The second member is arranged between the first member and the substrate, wherein the contact pads are arranged at the first member, preferably at its bottom. The first member has a cross section area that exceeds the cross section area of the second member. The cross section area is the area in the horizontal plane. The cross section area of the first member may be sufficient for arranging the contact pads and for providing a certain mechanical stability given that the contact pads may be the attachment point to a carrier. The cross section of the substrate generally is defined by the extension of the structure/s integrated into the substrate, etc. The cross section area of the substrate exceeds the cross section area of the second member of the support, such that when regarding the entire device, the second member may also be considered as a thinned portion within the support. This thinned portion has the following task: The second member with its reduced cross section area mechanically decouples the substrate from the first member at least to some extent. The second member evokes a kind of a single point / punctual mounting of the substrate with respect to the carrier. The problem that was observed is that during mounting of the device to the carrier, and/or later on during operation, mechanical stress may be evoked and transmitted via the solder balls to the substrate of the device and specifically to stress sensitive structures of the device. In case the device comprises a sensing element, such sensing element may in one embodiment comprise a membrane or may be arranged on a membrane which membrane in particular may be considered as a stress sensitive structure. Given that stress sensitive structures may encompass sensing elements, electronic circuitry, MEMS structures, mechanical structures, etc. subject to the embodiment of the device, and given that such structures are arranged on or integrated into the substrate, the present approach preferably mechanically decouples the substrate to some extent from the location of the mechanical coupling to the carrier. Hence, it is preferred that the support has a section, i.e. the second member, with a reduced cross section area compared to the substrate and the first member with the contact pads in order to act as a mechanical bottleneck for stress.

The smaller the cross section area of the second member is the less stress may migrate to the stress sensitive structure. Specifically, the cross section area of the second member is smaller than half of the cross section area of the substrate, and preferably is smaller than a fourth of the cross section area of the substrate. However, the cross section area of the second member preferably is more than a tenth of the cross section area of the substrate given that it is the member that also is responsible for mechanical stability. For enhancing the mechanical stability, there may be additionally provided pillars between the first member and the substrate, and specifically between the first member and a third member of the support which third member is arranged in between the substrate and the second member for electrically conducting the vias to the preferably vertical conductors in the second member. In view of the reduced cross section area of the second member with respect to the substrate and the first member, an air or vacuum gap occurs under the area of the substrate where the second member is not present. The one or more pillars may be arranged in these gaps and serve as additional structure supporting the substrate. In another embodiment, which is not claimed, the gap between the first member and the substrate or the third member respectively is filled by a suitable material, in particular a material being more elastic than a material of any of the first, the second and the third member. Such filler may provide for a certain stability in vertical direction while at the same time it may allow for a sufficient elasticity in the horizontal plane for disabling the migration of stress from the first member into the substrate.

In an embodiment, which is not claimed, when no third member is provided and the second member is attached to the bottom of the substrate - which in a preferred embodiment may include that the vias may end within the area where the second member meets the substrate - the one or more pillars may be arranged between the first member and the substrate. In case a third member of the support is provided and the support is attached to the substrate with this third member, the one or more pillars may be arranged between the first member and the third member. In case a third member of the support is provided, it is preferred that the substrate, the third member of the support and the first member of the support have the same cross section area, and have the same cross section shape.

In another embodiment, there may be provided multiple first members, e.g. two or three, and at the same time a corresponding number of second members, e.g. two or three respectively, wherein each first member is connected to the substrate via one assigned second member. The multiple first members are not in contact with each other, and the multiple second members are not in contact with each other in this example. In such embodiment, each of the first members has a cross section area that exceeds the cross section area of the assigned second member. And, preferably, an accumulated cross section area of all second members is smaller than an accumulated cross section area of all the first members. In a different embodiment, the support may have a single first member and multiple second members, e.g. two. Hence, the substrate is linked to the first member via the multiple second members, wherein preferably not only the cross section area of each second member is smaller than the cross section area of the first member, but also an accumulated cross section area of all second members is smaller than the cross section area of the first member. Summarizing, there may also be one or more first and/or second members provided in other embodiments.

In a preferred embodiment, the support comprises conductors for electrically connecting ends of the vias at the back side of the substrate to the contact pads. Specifically, the conductors in the first member are horizontally aligned wherein horizontal in this context is defined as a plane in parallel to the extension of the substrate. Conductors in the second members are aligned vertically.

In another preferred embodiment of the invention, the first member comprises through holes.

Other advantageous embodiments are listed in the dependent claims as well as in the description below.

### Brief Description of the Drawings

Embodiments of the present invention, aspects and advantages will become apparent from the following detailed description thereof. Such description makes reference to the annexed drawings, wherein the figures show:
FIG. 1 in diagram a) a device according to an embodiment of the present invention in a longitudinal cut, and an associate cross section view of a support of the device,
FIG. 2 the device according to FIG. 1 arranged on a carrier, in a longitudinal cut,
FIG. 3 a device comprising a pressure sensor according to an embodiment of the present invention, in a longitudinal cut,
FIG. 4 in diagram a) a device according to another embodiment of the present invention in a longitudinal cut, and an associate cross section view of a support of the device, and
FIG. 5 a longitudinal cut of a device according to another embodiment of the present invention.

### Modes for Carrying Out the Invention

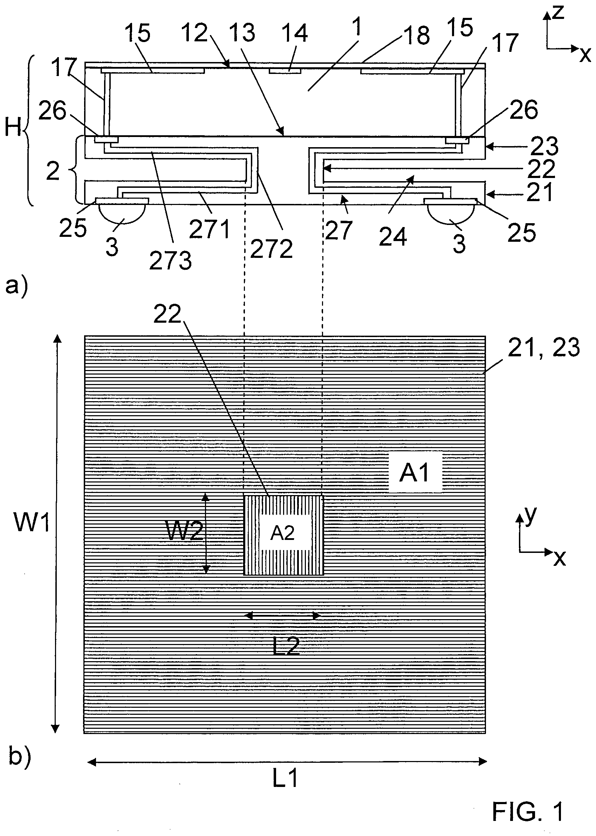

Figure 1 schematically illustrates in diagram a) a device in a longitudinal cut according to an embodiment of the present invention. The device, also denoted as chip, comprises a semiconductor substrate 1 arranged on a support 2. The substrate 1 has a length L1 in longitudinal direction x, a width W1 in transversal direction y and as such spans a cross section area A1=L1^{∗}W1 in a horizontal plane, see also diagram 1b). The substrate 1 further has a height H in vertical direction z. At its front side 12, electronic circuitry 15 is integrated into the substrate 1, e.g. by means of CMOS processing. Next to the electronic circuitry 15 a sensing element 14 is arranged at the front side 12. The sensing element 14 may be electrically connected to the electronic circuitry 15 by means of conductors not shown and may provide a sensor signal to the electronic circuitry 15 for processing and converting the sensor signal into the digital domain. The front side 12 of the substrate 1 preferably is covered by a passivation layer 18 for protecting the electronic circuitry 15 and the sensing element 14. Electrically conducting vias 17 are provided in through holes leading through the substrate 11 from the front side 12 to its back side 13.

The support 2 is made from a single piece of material, such as plastics, for example, and is virtually classified into three members: A first member 21 representing the bottom part of the support 2 includes contact pads 25 for connecting the device to the outside world at its bottom side, i.e. the side facing away from the substrate 1. The contact pads 25 may carry solder bumps/balls 3 as indicated in diagram 1a). A third member 23 of the support 2 is attached to the substrate 1, e.g. by bonding, and a second member 22 is arranged in between the first member 21 and the third member 23. Electrical interconnections 27 in the support 2 include first conductors 271 mainly oriented horizontally in the first member 21 and connected to contacts 26 which may be bonded to ends of the vias 17 in the substrate 1. The electrical interconnections 27 in the support 2 further comprise conductors 273 mainly oriented horizontally in the third member 23 and connected to the contact pads 25. The electrical interconnections 27 further comprise conductors 272 in the second member 22 mainly aligned vertically therein for connecting the conductors 271 in the first member 21 to the conductors 273 in the third member 23.

Hence, the device can be surface mounted onto a carrier via its contact pads 25. Especially, when the device includes a sensing element 14, such set-up of the device is preferred given that the sensing element 14 is directed towards the ambience and not against a carrier. At the same time, the device preferably is free of bond wires and cast and as such can be manufactured easily. Instead, an electrical path is implemented from/to the electronic circuitry 15 and/or the sensing element 14 and/or a mechanical structure to/from the contact pads 25 by means of the vias 17 and by means of the electrical interconnections 27 in the support 2.

Between the first member 21 and the third member 23 a gap 24 is provided in the support 2 outside the second member 22. In the present embodiment the cross section of the first member 21 is identical to the cross section of the third member 23 and to the cross section of the substrate 1. The cross section area A1 of the first member 21 is A1=L1^{∗}W1. However, a cross section area A2=L2^{∗}W2 of the second member 22 of the support 2 is less than the cross section area A1.

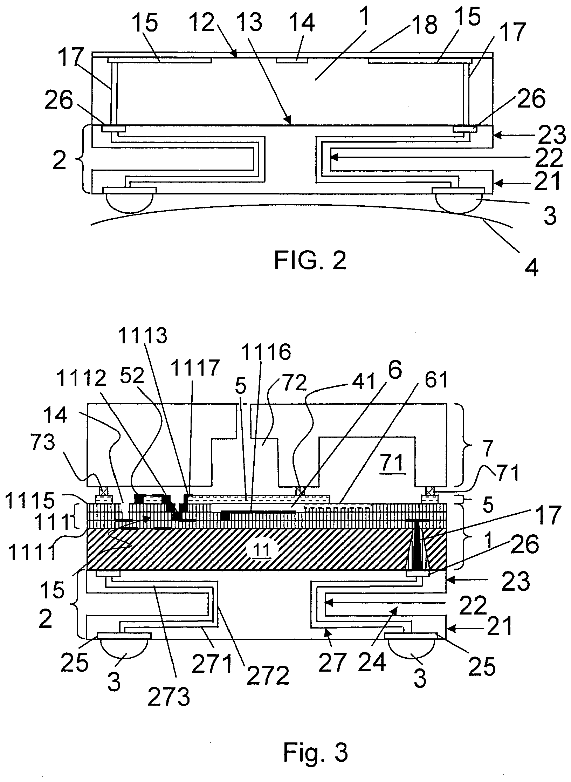

When the device is attached to a carrier 4 by means of the solder balls 3 such as shown in Figure 2, the different cross sectional areas A1 and A2 of the support members 21-23 and the substrate 1 lead to a single point mounting of the device to the carrier 4. Whenever stress is induced into the first member 21 of the support 2 - either during mounting the device to the carrier 4 or later on during operation because of the carrier may be bent such as indicated in Figure 2 - the stress induced via the solder balls 3 to the first member 21 may not be carried on to stress sensitive structures in/on the substrate 1. The stress sensitive structures in this embodiment are the sensing element 14 and the electronic circuitry 15. Stress induced into the first member 21 of the support 2 only can migrate via the second member 22 towards the substrate 1. Given that stress induced e.g. by bending the carrier 14 may be a stress in the horizontal plane, the second member 22 with its reduced cross section area A2 serves as a bottleneck for stress to migrate into the substrate 1 and into the sensitive structures. Hence, by introducing a support 2 to the back side 13 of the substrate 1 and by selectively reducing the cross section area of this support 2, stress migration into the substrate 1 and thus into the sensitive structures can significantly be reduced. Hence, the second member 22 acts as a member for decoupling the substrate 1 from stress induced into the first member 21.

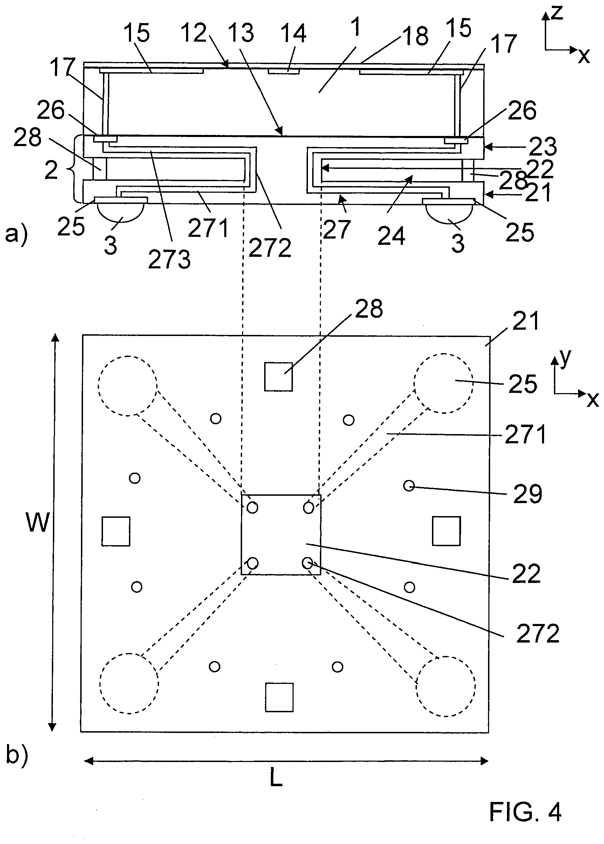

Figure 4 illustrates in diagram a) a device according to another embodiment of the present invention in a longitudinal cut. In this embodiment, the mechanical stability of the device is addressed. While many of the elements of the device are identical to the one shown in Figure 1, additional support is given by means of one or more pillars 28 arranged in the gap 24 between the first and the third member 21, 23 of the support 2. It may be preferred, in particular when a ratio of the cross section areas A1/A2 is large, e.g. > 4, that the pillars 28 provide for additional stability of the substrate 1. These pillars 28 may be made from the same material as the support 2, and in particular may be made from a single piece of material together with the rest of the support 2. These one or more pillars 28 may provide mechanical stability for the substrate 1 in vertical direction z and may prevent a bending of the second member 22. It is preferred that the one or more pillars 28 are rather stiff in z-direction and rather flexible in the horizontal plane defined by the x- and y-direction. The pillars 28 may be arranged at locations that tend to approach each other upon a deflection of the second member 22. In the present example, there are four pillars 28 introduced, one in each quarter of the first member 21. The one or more pillars 28 hence preferably represent the only other mechanical link between the first member 21 and the substrate 1 or the third member 23, and show a cross section area that is smaller and preferably much smaller, than, e.g. less than a tenth of the cross section area A2 of the second member 22 such that stress in the horizontal plane x or y may not or nearly not migrate via the pillars 28 into the substrate 1.

In diagram 4b), the cross section area of the first member 21 is shown in a top view, i.e. a view taken from the gap 24. The second member 22 rises with its conductors 272 from the middle of the first member 21. Contact pads 25 are either embedded in the first member 21 or arranged at the bottom of the first member 21. The ends of conductors 272 are connected to conductors 271 embedded in the first member 21 or arranged at the bottom of the first member 21. In addition, several through holes 29 are provided in the first member 21. These through holes 29 may serve the fabrication of the support 2: When the support 2 is made from a single piece of material such as a cuboid, it may be preferred to remove a portion of the material for forming the gaps 24. This may either be achieved from the sides of this cuboid, or from underneath the cuboid through the through holes 29. For example, an etchant may be supplied through the through holes 29 for etching the gaps 24.

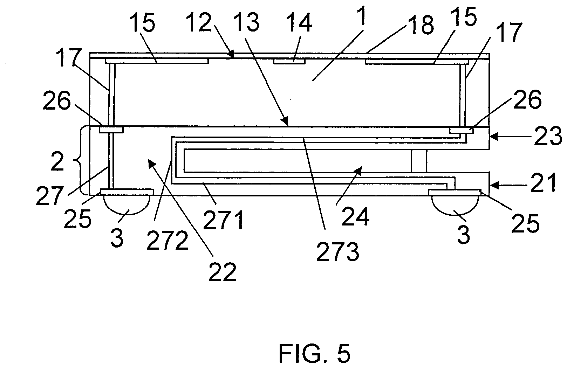

Figure 5 illustrates a longitudinal cut of a device according to another embodiment of the present invention. While the basic concept is the same as in the embodiments of Figures 1 and 4, the second member 22 of the support 2 is now arranged at a different location with respect to the first and third members 21 and 23 and with respect to the substrate 1. The second member 22 may now be arranged at a side of the substrate 1, or, as is shown in the present example in a corner of the substrate 1. Again, the cross sectional area A2 of the second member 22 is smaller than the cross sectional area of the substrate 1 and the cross sectional area A1 of the first member 21. In such embodiment, it may be possible to directly connect at least one via 17 by means of a contact 26 and a straight conductor 27 to the contact pad 25. However, the other conductors 273 and 271 become longer in view of the increased distance of the other vias 17 to the second member 22. The present embodiment may provide one or more pillars 28 in view of the asymmetry of the support 2 which causes the substrate 1 to have a higher moment of forces at the locations far from the second member 22.

FIG. 3 shows a device comprising a pressure sensor according to an embodiment of the present invention in a longitudinal cut. In the present example, the substrate 1 and its structures is elaborated a bit more.

The device again includes a semiconductor substrate 1. The semiconductor substrate 1 is made from silicon and has various layers and structures 111 applied through a CMOS manufacturing processes as known per se. The layers and structures 111 can include for example a plurality of SiO2 layers 1111 and metal or polysilicon layers 1112, 1113 or other doped regions (not shown) within the silicon. These elements can form an active electronic circuitry 15, such as, for example, including amplifiers, A/D converters or other analogue and/or digital signal processing units. The semiconductor substrate 11 carries a topmost dielectric layer 1115 of silicon oxide and/or silicon nitride for protecting the structures underneath.

Further, a pressure sensitive membrane 5 is applied over the silicon substrate 1. In the embodiment of Fig. 3, the membrane 5 is formed by a doped, conducting silicon layer. The membrane 5 is sufficiently thin such that it de-forms depending on the pressure drop between the pressure at the top of the membrane 5 and underneath it. The deformation is sufficient to allow a measurement of this pressure. The membrane 5 is arranged as a sealing lid over a cavity 6. The cavity 6 is accessible through a channel 61. In the figure, the channel 61 is shown extending below membrane 5 and connecting the cavity 6 to an opening at the top side. This opening leads into a recess 71 formed with the aid of a cap structure 7. The cap structure 7 preferably is a thick, mechanically stable and inert structure and can be manufactured from a silicon wafer or a glass wafer. The cap structure 7 further includes a port hole 72 going through the cap structure 7 and providing access to the membrane 5 for fluids from the outside of the device.

The recess 71 is sealed by a eutectic bond 71 effectively leaving the recess 71 and the cavity 6 in pressure communication with each other but sealed to the outside. In this arrangement the cavity 6 forms a measuring chamber and the recess 71 serves as a buffer chamber providing a large volume to improve the vacuum in the smaller measuring chamber 6.

At the bottom of the cap structure 7, a second seal 73 surrounds the area with the port 72 and the recess 71 at the level between the membrane 5 and the cap substrate 7. Essentially all of the volume between seal 73 and seal 72 may be accessible through the port 72. In order to prevent leakage from this volume into the measuring chamber 6, it can be advantageous to provide additional hermetic seals 52 at locations in the membrane 5 which give potentially access to the interface between the membrane 5 and cap structure 7. In the present example such seals 52 are provided by depositing a barrier of aluminium onto edges of the membrane 5.

In the present embodiment, the pressure sensing element is a capacitive sensor with the membrane 5 forming a first electrode at the top side of the cavity 6 connected via suitable metal leads 1117 to a metal layer (such as the M6 layer, not shown) of the circuitry 15 on the semiconductor chip 1. A second electrode 1116 is arranged at the bottom side of the cavity 6 and is also connected to the circuitry 15 of the device. Depending on the pressure drop over membrane 5, the electrical capacitance between membrane 5 and electrode 1116 will vary, thereby allowing the pressure drop (or any quantity dependent thereon) to be measured.

The electronic circuitry 15 of the sensor of Figs. 1 is contacted electrically from the outside through a hole created and refilled using a process known per se as "through-silicon via" or TSV or similar processes. The hole passes through the substrate 1 from its back side 13 to its front side 12 where the CMOS layers are and connects to a metal layer within layers 1113. The contact wire in hole, collectively denoted as via 17, is insulated from the substrate by a Silicon dioxide layer surrounding the metal core. The "through-silicon" contact leaves the top of the sensor free from contact leads to the outside and facilitates a more compact design of the whole sensor and sensor package. Underneath the substrate 1, a support 2 is provided as is explained with respect to the other Figures.

Generally, the support 2 may be envisaged as redistribution layer that connects the vias 17 in the substrate 1 with contacts pads 25 having a different pattern than the vias 17. The redistribution layer further acts as a stress limiting layer as is explained above.

## Claims

1. Device with one or more of a micro- or nanoscale mechanical structure, a micro- or nanoscale sensing element (14), an active and/or passive micro- or nanoscale electrical circuitry (15), integrated at a front side (12) of a substrate (1), the device further comprising
- a support (2) arranged at a back side (13) of the substrate (1) for mounting the device to a carrier (4), wherein the support (2) comprises a first member (21) comprising contact pads (25) for electrically connecting the device to the carrier (4), a second member (22) in between the first member (21) and the substrate (1), and a third member (23) between the second member (22) and the substrate (1),
- one or more vias (17) extending through the substrate (1) for providing an electrical connection between the front side of the substrate and its back side,
- an air or vacuum gap (24) between the first member (21) and the third member (23) outside the second member (22),
wherein the second member (22) has a cross section area (A2) smaller than a cross section area.of the substrate (1) and smaller than a cross section area (A1) of the first member (21),
wherein the third member (23) has a cross section area exceeding the cross section area (A2) of the second member (22).

2. Device according to claim 1,
wherein the sensing element (14) is an element for sensing at least one of pressure, humidity, a chemical substance, a flow of a fluid, temperature, stress, electromagnetic radiation, or mechanical vibration.

3. Device according to any one of the preceding claims,
wherein the substrate (1) is a semiconductor substrate, and
wherein the device comprises at the front side (12) of the substrate (1) the sensing element (14), a processing unit for processing a signal of the sensing element (14) including an analogue to digital converter, wherein a digitized processed sensor signal is supplied to the contact pads (25).

4. Device according to any one of the preceding claims,
wherein the cross section area (A2) of the second member (22) is smaller than half of the cross section area of the substrate (1), and preferably is smaller than a fourth of the cross section area of the substrate (1) .

5. Device according to claim 1,
comprising one or more pillars (28) arranged in the gap (24) between the first member (21) and the third member (23), and
in particular wherein the one or more pillars are flexible in a horizontal plane.

6. Device according to any one of the preceding claims,
wherein the device comprises the sensing element (14), and
wherein the sensing element (14) is arranged on a membrane, or comprises a membrane.

7. Device according to any one of the preceding claims,
wherein the support (2) comprises conductors (27) for electrically connecting ends of the vias (17) at the back side (13) of the substrate (1) to the contact pads (25).

8. Device according to claim 7,
wherein conductors (271) in the first member (21) are horizontally aligned, and
wherein conductors (272) in the second member (22) are vertically aligned.

9. Device according to any one of the preceding claims,
wherein the first member (21) comprises through holes (29).

10. Device according to any one of the preceding claims,
wherein the support (2) comprises at least two and at most three first members (21) each first member (21) comprising contact pads (25) for electrically connecting the device to the carrier (4), and two or three second members (22) respectively wherein each second member (22) is arranged in between the associate first member (21) and the substrate (1).

11. Device according to claim 10,
wherein the first members (21) are not connected to each other,
wherein the second members (22) are not connected to each other, and
wherein a combined cross section area of the second members (22) is smaller than a cross section area of the substrate (1) and smaller than a combined cross section area (A1) of the first members (21).

## Patentansprüche

1. Vorrichtung mit einer oder mehreren einer mechanischen Mikroskalen- oder Nanoskalen-Struktur, einem Mikroskalen- oder Nanoskalen-Erfassungsbauteil (14) und einer aktiven und/oder passiven elektrischen Mikroskalen- oder Nanoskalen-Schaltungsanordnung (15), die an einer Vorderseite (12) eines Substrats (1) integriert ist, wobei die Vorrichtung ferner Folgendes umfasst:
- eine Stütze (2), die auf einer Rückseite (13) des Substrats (1) angeordnet ist, um die Vorrichtung an einem Träger (4) zu montieren, wobei die Stütze (2) ein erstes Element (21), das Kontaktplättchen (25) zum elektrischen Verbinden der Vorrichtung mit dem Träger (4), ein zweites Element (22) zwischen dem ersten Element (21) und dem Substrat (1) und ein drittes Element (23) zwischen dem zweiten Element (22) und dem Substrat (1) umfasst,
- ein oder mehrere Kontaktlöcher (17), die sich durch das Substrat (1) erstrecken, um eine elektrische Verbindung zwischen der Vorderseite des Substrats und seiner Rückseite bereitzustellen, und
- einen Luft- oder Unterdruckspalt (24) zwischen dem ersten Element (21) und dem dritten Element (23) außerhalb des zweiten Elements (22),
wobei das zweite Element (22) eine Querschnittsfläche (A2) aufweist, die kleiner als eine Querschnittsfläche des Substrats (1) und kleiner als eine Querschnittsfläche (A1) des ersten Elements (21) ist, und
wobei das dritte Element (23) eine Querschnittsfläche aufweist, die größer als die Querschnittsfläche (A2) des zweiten Elements (22) ist.

2. Vorrichtung nach Anspruch 1,
wobei das Erfassungsbauteil (14) ein Bauteil zum Erfassen von Druck und/oder Feuchtigkeit und/oder einer chemischen Substanz und/oder einer Fluidströmung und/oder Temperatur und/oder Beanspruchung und/oder elektromagnetischer Strahlung und/oder mechanischer Schwingung ist.

3. Vorrichtung nach einem der vorhergehenden Ansprüche,
wobei das Substrat (1) ein Halbleitersubstrat ist und
wobei die Vorrichtung das Erfassungsbauteil (14) und eine Verarbeitungseinheit zum Verarbeiten eines Signals des Erfassungsbauteils (14), das einen Analog/Digital-Umsetzer enthält, auf der Vorderseite (12) des Substrats (1) umfasst, wobei ein digitales verarbeitetes Sensorsignal an die Kontaktplättchen (25) geliefert wird.

4. Vorrichtung nach einem der vorhergehenden Ansprüche,
wobei die Querschnittsfläche (A2) des zweiten Elements (22) kleiner ist als die Hälfte der Querschnittsfläche des Substrats (1) und bevorzugt kleiner ist als ein Viertel der Querschnittsfläche des Substrats (1).

5. Vorrichtung nach Anspruch 1,
die einen oder mehrere Pfeiler (28) umfasst, die in dem Spalt (24) zwischen dem ersten Element (21) und dem dritten Element (23) angeordnet sind, und
insbesondere wobei der eine oder die mehreren Pfeiler in einer horizontalen Ebene biegsam sind.

6. Vorrichtung nach einem der vorhergehenden Ansprüche,
wobei die Vorrichtung das Erfassungsbauteil (14) umfasst und
wobei das Erfassungsbauteil (14) auf einer Membran angeordnet ist oder eine Membran umfasst.

7. Vorrichtung nach einem der vorhergehenden Ansprüche,
wobei die Stütze (2) Leiter (27) umfasst, um Enden der Kontaktlöcher (17) auf der Rückseite (13) des Substrats (1) mit den Kontaktplättchen (25) elektrisch zu verbinden.

8. Vorrichtung nach Anspruch 7,
wobei Leiter (271) in dem ersten Element (21) horizontal ausgerichtet sind und
wobei Leiter (272) in dem zweiten Element (22) vertikal ausgerichtet sind.

9. Vorrichtung nach einem der vorhergehenden Ansprüche,
wobei das erste Element (21) Durchgangslöcher (29) umfasst.

10. Vorrichtung nach einem der vorhergehenden Ansprüche,
wobei die Stütze (2) mindestens zwei und höchstens drei erste Elemente (21), wobei jedes erste Element (21) Kontaktplättchen (25) zum elektrischen Verbinden der Vorrichtung mit dem Träger (4) umfasst, und entsprechend zwei oder drei zweite Elemente (22), wobei jedes zweite Element (22) zwischen dem zugeordneten ersten Element (21) und dem Substrat (1) angeordnet ist, umfasst.

11. Vorrichtung nach Anspruch 10,
wobei die ersten Elemente (21) nicht miteinander verbunden sind,
wobei die zweiten Elemente (22) nicht miteinander verbunden sind und
wobei eine kombinierte Querschnittsfläche der zweiten Elemente (22) kleiner als eine Querschnittsfläche des Substrats (1) und kleiner als eine kombinierte Querschnittsfläche (A1) der ersten Elemente (21) ist.

## Revendications

1. Dispositif doté d'une structure mécanique micro ou nanométrique et/ou d'un élément capteur micro ou nanométrique (14) et/ou d'une circuiterie électrique micro ou nanométrique active et/ou passive (15), intégrés au niveau d'un côté avant (12) d'un substrat (1), le dispositif comprenant en outre :
- un support (2), agencé au niveau d'un côté arrière (13) du substrat (1), permettant de monter le dispositif sur un élément porteur (4), le support (2) comprenant un premier organe (21) comprenant des plots de contact (25) permettant de connecter électriquement le dispositif à l'élément porteur (4), un deuxième organe (22) entre le premier organe (21) et le substrat (1) et un troisième organe (23) entre le deuxième organe (22) et le substrat (1),
- un ou plusieurs vias (17) s'étendant au travers du substrat (1) permettant d'assurer une connexion électrique entre le côté avant du substrat et son côté arrière,
- un espace d'air ou sous vide (24) entre le premier organe (21) et le troisième organe (23) à l'extérieur du deuxième organe (22),
le deuxième organe (22) présentant une aire de section droite (A2) inférieure à une aire de section droite du substrat (1) et inférieure à une aire de section droite (A1) du premier organe (21),
le troisième organe (23) présentant une aire de section droite supérieure à l'aire de section droite (A2) du deuxième organe (22).

2. Dispositif selon la revendication 1,
dans lequel l'élément capteur (14) est un élément permettant de capter une pression et/ou une humidité et/ou une substance chimique et/ou un écoulement d'un fluide et/ou une température et/ou une contrainte et/ou un rayonnement électromagnétique et/ou une vibration mécanique.

3. Dispositif selon l'une quelconque des revendications précédentes,
dans lequel le substrat (1) est un substrat semiconducteur, et
lequel dispositif comprend, au niveau du côté avant (12) du substrat (1), l'élément capteur (14), une unité de traitement permettant de traiter un signal de l'élément capteur (14) comportant un convertisseur analogique-numérique, un signal de capteur traité numérisé étant fourni aux plots de contact (25).

4. Dispositif selon l'une quelconque des revendications précédentes,
dans lequel l'aire de section droite (A2) du deuxième organe (22) est inférieure à la moitié de l'aire de section droite du substrat (1) et, de préférence, est inférieure à un quart de l'aire de section droite du substrat (1).

5. Dispositif selon la revendication 1,
comprenant un ou plusieurs piliers (28) agencés dans l'espace (24) entre le premier organe (21) et le troisième organe (23), et
plus particulièrement dans lequel les un ou plusieurs piliers sont flexibles dans un plan horizontal.

6. Dispositif selon l'une quelconque des revendications précédentes,
lequel dispositif comprend l'élément capteur (14), et
dans lequel l'élément capteur (14) est agencé sur une membrane ou comprend une membrane.

7. Dispositif selon l'une quelconque des revendications précédentes,
dans lequel le support (2) comprend des conducteurs (27) permettant de connecter électriquement des extrémités des vias (17) au niveau du côté arrière (13) du substrat (1) aux plots de contact (25).

8. Dispositif selon la revendication 7,
dans lequel des conducteurs (271) dans le premier organe (21) sont alignés horizontalement, et
dans lequel des conducteurs (272) dans le deuxième organe (22) sont alignés verticalement.

9. Dispositif selon l'une quelconque des revendications précédentes,
dans lequel le premier organe (21) comprend des trous traversants (29).

10. Dispositif selon l'une quelconque des revendications précédentes,
dans lequel le support (2) comprend au moins deux et au plus trois premiers organes (21), chaque premier organe (21) comprenant des plots de contact (25) permettant de connecter électriquement le dispositif à l'élément porteur (4), et deux ou trois deuxièmes organes (22) respectivement, chaque deuxième organe (22) étant agencé entre le premier organe associé (21) et le substrat (1).

11. Dispositif selon la revendication 10,
dans lequel les premiers organes (21) ne sont pas connectés les uns aux autres,
dans lequel les deuxième organes (22) ne sont pas connectés les uns aux autres, et
dans lequel une aire de section droite combinée des deuxièmes organes (22) est inférieure à une aire de section droite du substrat (1) et inférieure à une aire de section droite combinée (A1) des premiers organes (21) .
